(19) Europäisches Patentamt
European Patent Office
Office européen des brevets

(11) **EP 2 546 852 B1**

(12) **EUROPÄISCHE PATENTSCHRIFT**

(45) Veröffentlichungstag und Bekanntmachung des Hinweises auf die Patenterteilung:
**30.08.2017** **Patentblatt 2017/35**

(51) Int Cl.:
*H01H 47/22* *(2006.01)*     *H01H 47/32* *(2006.01)*
*G01R 27/26* *(2006.01)*     *G01R 31/02* *(2006.01)*

(21) Anmeldenummer: **12004928.3**

(22) Anmeldetag: **03.07.2012**

(54) **Bistabiles Sicherheitsrelais**

Bi-stable security relay

Relais de sécurité bistable

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **14.07.2011 DE 102011107734**

(43) Veröffentlichungstag der Anmeldung:
**16.01.2013 Patentblatt 2013/03**

(73) Patentinhaber: **Phoenix Contact GmbH & Co. KG**
**32825 Blomberg (DE)**

(72) Erfinder:
• **Rohs, Markus**
**32825 Blomberg (DE)**
• **Eilers, Markus**
**31812 Bad Pyrmont (DE)**

(74) Vertreter: **Blumbach Zinngrebe**
**Patentanwälte**
**Alexandrastrasse 5**
**65187 Wiesbaden (DE)**

(56) Entgegenhaltungen:
**EP-A1- 2 290 383**     **EP-A1- 2 383 764**
**DE-A1- 10 022 722**     **DE-A1- 10 140 559**
**US-A- 3 414 792**

EP 2 546 852 B1

**Beschreibung**

Die vorliegende Erfindung betrifft eine Schaltvorrichtung zum Bereitstellen sicherheitsrelevanter Funktionen in der Automatisierungstechnik mit einem gepufferten bistabilen elektromechanischen Relais sowie ein Testverfahren zur Überwachung der Schaltvorrichtung.

In der Automatisierungstechnik wird sowohl die Steuerung von Prozessen als auch die Steuerung sicherheitsrelevanter Funktionen von elektronischen Steuerungseinrichtungen z.B. von speicherprogrammierbaren Steuerungen (SPS) übernommen. Diese Steuerungseinrichtungen verfügen unter Anderem über eine Anzahl digitaler Ausgänge, über die elektrische Lasten in einem automatisierten System angesteuert werden können. Oftmals ist der an den digitalen Ausgängen maximal bereitstehende elektrische Strom für eine direkte Versorgung einer jeweiligen elektrischen Last nicht ausreichend, so dass die jeweiligen Ausgangssignalkreise der Steuerungseinrichtung von den Laststromkreisen der Lasten entkoppelt werden müssen. Eine solche Entkopplung erfolgt in der Automatisierungstechnik in der Regel über sog. Koppelrelais, die ein elektromechanisches Relais mit wenigstens einem Ausgangsstromkreis enthalten können.

Zum Ansteuern von sicherheitsrelevanten Funktionen in einem Automatisierungssystem werden Koppelrelais eingesetzt, die einem festgelegten Sicherheit-Integritäts-Level (SIL) genügen müssen. D.h., dass diese Koppelrelais eine bestimmte Sicherheitsanforderungsstufe zum Beispiel gemäß der internationalen Norm IEC 61508 erfüllen müssen.

In der Sicherheitstechnik werden in der Regel unipolare elektromechanische Relais verwendet, die nach dem sog. Ruhestromprinzip arbeiten. Diese Relais werden bei einer am Relaiseingang anliegenden Spannung angezogen, so dass die Ausgangstromkreise, die sowohl Öffner- als auch Schließer-Kontakte besitzen können, in einen entsprechend gesetzten Zustand geschaltet werden. Wird diese Eingangsspannung am Relais zurückgenommen, fällt auch das unipolare Relais ab und wird zurückgesetzt. Der Schaltzustand der jeweiligen Ausgangstromkreise ändert sich dementsprechend.

Das Ruhestromprinzip erfüllt unter anderem in Verbindung mit sog. zwangsgeführten Schaltkontakten in den unipolaren elektromechanische Relais eine hohe Sicherheitsanforderung in Bezug auf die Ausfallsicherheit. Bei einem Ausfall der Spannung am Relaiseingang nimmt das unipolare Relais zwangsweise und damit sicher einen definierten, d.h. bevorzugt einen zurückgesetzten Schaltzustand ein.

Für ein im Folgenden als Sicherheitsrelais bezeichnetes Relais können neben der Ausfallsicherheit noch weitere Anforderungen, zum Beispiel einer Testbarkeit des Eingangs- und/oder Ausgangskreises gefordert sein. Dazu kann z.B. den elektromechanischen Relaiskomponenten eine elektronische Schaltungseinrichtung zugeordnet sein, die entsprechende Testmittel bereitstellen kann.

Der Erregerstrom für die Spule eines Sicherheitsrelais kann direkt vom Ausgangssignalkreis einer Steuerungseinrichtung, d.h. über ein Eingangssignalanschluss des Sicherheitsrelais bereitgestellt werden. Alternativ könnte der Strom auch von einer separaten Hilfsenergieversorgungseinrichtung bereitgestellt werden. Der Strom kann in Abhängigkeit eines Spannungspegels an dem Eingangssignalanschluss über eine elektronische Schaltung schaltbar der Spule zugeführt werden.

In der Sicherheitstechnik werden die unipolaren Relais in einem Sicherheitsschaltgerät üblicher Weise mit Nennleistung (100 % Duty Cycle) betrieben. Es besteht zwar grundsätzlich die Möglichkeit, die Spannung an der Spule des Relais z.B. mit einem zuschaltbaren Vorwiderstand abzusenken oder die Spule mit einem pulsweitenmodulierten Signal weiter zu betreiben, nachdem das unipolare Relais angezogen hat, so dass die Leistungsaufnahme während des Haltungszustandes reduziert wird. In jedem Fall ist eine relativ große Leistung zum Betreiben eines unipolaren Relais erforderlich, die in einem jeweiligen Steuerungssystem als Verlustleistung von der Steuerungseinrichtung oder von der separaten Hilfsenergieversorgungseinrichtung bereitgestellt werden muss.

Als Koppelrelais zum Entkoppeln eines Ausgangssignalkreises einer Steuerungseinrichtung von einem Laststromkreis einer anzusteuernden Automatisierungseinrichtung (d.h. einer jeweiligen Last) können grundsätzlich auch bistabile Relais verwendet werden. Diese bistabilen Relais können z.B. durch einen zeitlich begrenzten Signalimpuls am Relaiseingang von einem ersten mechanisch stabilen Schaltzustand in einen zweiten stabilen Schaltzustand wechseln. Das bistabilen Relais könnte z.B. durch einen zweiten Signalimpuls zurückgesetzt werden, wobei der Spannungsimpuls ggf. eine umgekehrte Polarität zu der des ersten Spannungsimpulses aufweist. Mit einer separaten Hilfsenergieversorgungseinrichtung und einer Schaltung am Relaiseingang könnte auch eine zum Ausgangssignal für die unipolaren Relais kompatible Ansteuerung erfolgen.

Die Spule eines bistabilen Relais nimmt in der Regel nur während eines Umschaltvorganges eine entsprechende Leistung auf. In den beiden stabilen Schaltzuständen benötigt die Spule eines bistabilen Relais keinen Erregerstrom.

Obwohl die bistabilen Relais sich durch einen geringeren Energiebedarf und einer vom Schaltzustand unabhängigen Verlustleistungsaufnahme auszeichnen, gelten diese für die Sicherheitstechnik als ungeeignet. Insbesondere durch das nicht erfüllte Ruhestromprinzip können die SIL-Anforderung beispielsweise in Bezug auf die Ausfallsicherheit nicht gewährleistet werden. Zum Beispiel würde beim Ausfall der Hilfsenergieversorgungseinrichtung das bistabile Relais in seinem aktuellen Zustand verharren, so dass ein sicherer Schaltzustand nicht zwangsläufig eingenommen wird.

Aus DE 101 40 559 A1 ist eine Elektromagnetanordnung für einen Schalter bekannt, die Teil eines bistabilen Relais sein kann und bei der die Verlustleistung im Haltebetrieb möglichst reduziert ist. Die Erregerwicklung der Magnetanordnung ist mit einem Energiespeicher verschaltet, dessen Energieinhalt ausreicht, den Magnetanker aus dem Haltezustand zu lösen. Eine Überwachungseinheit ist zur Kontrolle des Spannungszustandes des Energiespeichers vorgesehen, so dass die Anordnung entweder auf eine andere Energiequelle umgeschaltet oder ein Fehlersignal gemeldet werden kann. Um ein bistabiles Relais für die Sicherheitstechnik einsetzbar zu machen, muss das bistabile Relais bei Ausfall der Stromversorgung in den sicheren Zustand geschaltet werden und es müssen sicherheitsgerichtete Funktionen eines Automatisierungssystems bereitgestellt werden können.

Die EP 2 383 764 A1 zeigt ein bistabiles Relais mit einer Spulenanordnung und einem beweglichen Anker zum Öffnen und Schließen von Kontakten und mit einem Permanentmagneten, mit dem der Anker in seiner Position fixierbar ist. Die Energie des Speichers dient dazu, den Anker in seine Aus-Position des Relais zu bewegen. In der Steuereinheit des Relais kann ein integrierter Unterspannungsschutz vorgesehen sein, um das Relais vor unbestimmten Betriebszuständen zu sichern.

EP 2 290 383 A1 bezieht sich auf eine Diagnosevorrichtung zur Abschätzung der verbleibenden Lebensdauer eines Kondensators. Hierzu wird der Kondensator bei unterschiedlichen Temperaturen nahezu vollständig entladen und es werden dabei Strom- und Spannungsverläufe gemessen, was zur Beurteilung der Restlebensdauer des Kondensators dient.

Die vorliegende Erfindung hat sich daher die Aufgabe gestellt, trotz der geläufigen sicherheitstechnischen Bedenken, ein bistabiles elektromechanisches Relais für die Sicherheitstechnik einsetzbar zu machen.

Zur Lösung dieser Aufgabe schlägt die vorliegende Erfindung eine Schaltvorrichtung gemäß dem unabhängigen Anspruch 1 und ein Testverfahren gemäß dem nebengeordneten Anspruch 10 vor. Beispielhafte Ausgestaltungen und vorteilhafte Weiterbildungen der Erfindung sind Gegenstand der jeweils abhängigen Ansprüche.

Demgemäß umfasst eine Schaltvorrichtung ein bistabiles Relais, eine Steuerungseinrichtung, einen Energiespeicher sowie eine Testeinrichtung. Das bistabile Relais besitzt wenigstens einen Ausgangssignalkreis und ist in Abhängigkeit von einem Eingangsspannungssignal zwischen zwei Zuständen umschaltbar, wobei die Steuerungseinrichtung zum Ansteuern des Relais ausgebildet ist. Der Energiespeicher dient zum Bereitstellen einer Energie für wenigstens einen Zustandswechsel des bistabilen Relais. Die Testeinrichtung ist zum Testen der Funktionsfähigkeit des Energiespeichers ausgebildet.

Der Energiespeicher ermöglicht eine von externen Komponenten eines Sicherheitssystems unabhängige Energieversorgung, die ein sicheres Schalten des bistabilen Relais ermöglicht. Mit dem Testen der Funktionsfähigkeit des Energiespeichers wird eine in der Sicherheitstechnik übliche Anforderung z.B. gemäß der europäischen Norm EN 61508-2 erreicht.

Die Steuerungseinrichtung und die Testeinrichtung können miteinander in Verbindung stehen und dazu ausgebildet sein, beim Erkennen eines Fehlers des Energiespeichers das bistabile Relais in einen definierten sicheren Zustand zu setzen.

Hiermit wird der Sicherheits-Integritäts-Level (SIL) weiter erhöht, da ein entsprechendes mit der erfindungsgemäßen Schaltvorrichtung ausgestattetes Sicherheitsschaltgeräts in einem Fehlerfall selbständig in einen sicheren Schaltzustand schaltet. Ein solches Sicherheitsschaltgerät weist somit quasieigensichere Eigenschaften auf.

Ergänzend kann die Steuerungseinrichtung dazu ausgebildet sein, einen erkannten Fehler an externen Komponenten eines Sicherheitssystems zu signalisieren und einen weiteren Abschaltweg zu initiieren.

Die Testeinrichtung der Schaltvorrichtung kann einen Messstrompfad besitzen, der zum Energiespeicher parallel geschaltet ist.

Der Messstrompfad kann bevorzugt einen Konstantstromregler, einen Messwiderstand und ein Schaltelement besitzen.

In bevorzugter Weise kann die Testeinrichtung einen Testsignalanschluss und einen ersten Messsignalanschluss aufweisen. Der Messstrompfad ist somit vorteilhaft von der Steuerungseinrichtung über den Testsignalanschluss schaltbar. Über den ersten Messsignalanschluss ist ein durch den Messstrompfad fließender Strom von der Steuerungseinrichtung erfassbar.

Eine an dem Energiespeicher anliegende Spannung ist vorzugsweise über einen zweiten Messsignalanschluss von der Steuerungseinrichtung erfassbar.

In einer Weiterbildung kann die Testeinrichtung eine Ladeeinrichtung zum Aufladen des Energiespeichers aufweisen.

Die Testeinrichtung kann zum zyklischen Testen und die Ladeeinrichtung zum zyklischen Aufladen des Energiespeichers ausgebildet sein.

Der Energiespeicher der Schaltvorrichtung kann bevorzugt einen Kondensator aufweisen. Alternativ könnte der Energiespeicher auch einen Akkumulator umfassen.

Zur Lösung der Aufgabe schlägt die vorliegende Erfindung auch ein Testverfahren zum Testen der Funktionsfähigkeit eines Energiespeichers einer zuvor beschriebenen Schaltvorrichtung vor. Das Testverfahren umfasst dabei wenigstens die nachfolgenden Schritte:

a) Aufladen des Energiespeichers;
b) Entladen des Energiespeichers mit einem definierten konstanten Strom während einer vorbestimmten Testzeit;

c) Messen der am Energiespeicher während der Testzeit anliegenden Spannung;

d) Ermitteln der Kapazität des Energiespeichers in Abhängigkeit der in Schritt c) gemessenen Spannung und Prüfen, ob die Kapazität innerhalb eines definierten Wertebereichs liegt.

Die genannten Schritte a) und d) des Testverfahrens werden vorzugsweise zyklisch wiederholt.

Das Testverfahren ermöglicht, dass ein Fehler im Energiespeicher in Abhängigkeit eines Abweichens der ermittelten Kapazität von dem definierten Wertbereich erkannt werden kann.

Das zyklische Wiederholen der Schritte a) bis d) erfolgt vorzugsweise periodisch mit einer konstanten Frequenz, wobei die Testperiode zum Beispiel eine Periodenlänge im Bereich von 10 ms bis 100 ms haben kann. Das erzeugte periodische Testsignal ermöglicht eine quasikontinuierliche Überprüfung des Energiespeichers.

Ein Abweichen der Kapazität kann somit dynamisch erfasst werden, in dem ein Verstimmen des periodisches Testsignals von der Steuerungseinrichtung 10 erfasst wird.

Der Strom kann in einer vorteilhaften Weiterbildung des Testverfahrens während des Entladenes ermittelt werden, so dass in Abhängigkeit eines Abweichens des ermittelten Stroms vom Wert des definierten konstanten Stroms ein Fehler im Energiespeicher und/oder im Messstrompfad erkannt werden kann.

Das Testverfahren kann vorsehen, dass beim Erkennen eines Fehlers das Sicherheitsrelais in einen sicheren Zustand gesetzt wird.

Die Erfindung wird nachfolgend anhand einer beispielhaften Ausführungsform unter Bezugnahme auf die beiden beigefügten Zeichnungen detailliert beschrieben. In den Zeichnungen zeigen:

Fig. 1 ein Blockschaltbild eines Sicherheitsvorrichtung mit einer erfindungsgemäßen Schaltvorrichtung;

Fig. 2 ein Schaltbild einer Testschaltung mit einem parallel geschalteten Energiespeicher.

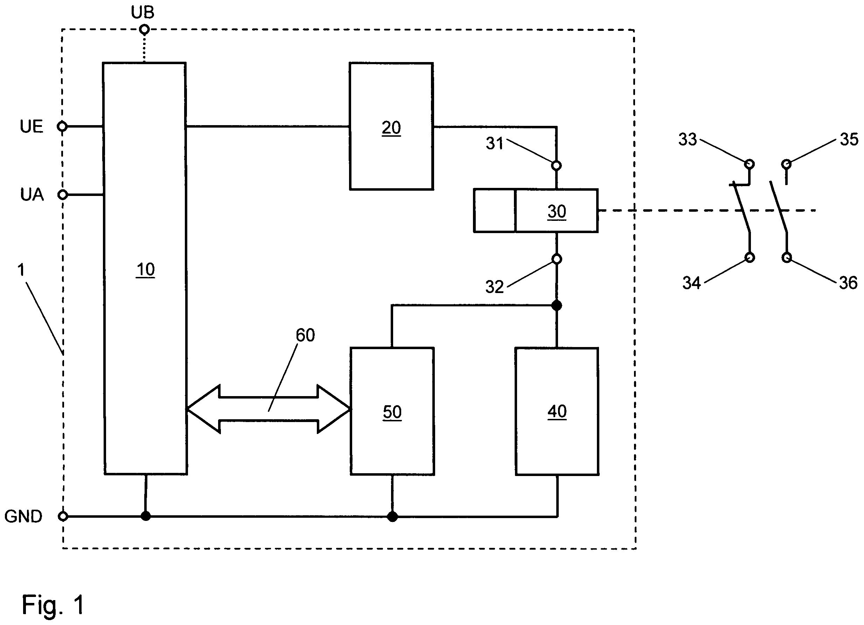

Die Figur 1 zeigt beispielhaft ein Blockschaltbild einer erfindungsgemäßen Schaltvorrichtung 1, die für ein bistabiles Sicherheitsrelais geeignet ist. Diese Schaltvorrichtung 1 umfasst eine Steuerungseinrichtung 10 mit einem Eingangssignalanschluss UE für ein Eingangsspannungssignal und mit einem Masseanschluss GND mit einem Bezugspotential. Die zwei Anschlüsse UE und GND bilden den Signaleingangskreis der Schaltvorrichtung 1 und dienen zum Anschließen zum Beispiel an den Ausgangssignalkreis einer in der Figur 1 nicht dargestellten speicherprogrammierbaren Steuerung (SPS).

Eine entsprechende SPS ist vorzugsweise zum Bereitstellen sicherheitsgerichteter Funktionen eines Automatisierungssystems ausgebildet und stellt an einem digitalen Ausgang (d.h. einem Ausgangssignalkreis) das Eingangssignal zum Ansteuern des Sicherheitsrelais bereit. Ein solcher digitaler Ausgang kann je nach Anforderung an den Sicherheits-Integritäts-Level (SIL) dazu ausgebildet sein, den Eingangssignalkreis auf Fehler in der Verdrahtung oder auf Fehler im Eingangsbereich des Sicherheitsrelais zu überwachen, wobei die Steuerungseinrichtung 10 auf eine solche Überwachungsfunktionalität zum Beispiel mit einer entsprechenden Eingangsimpedanz angepasst sein kann.

Die dargestellte Schaltvorrichtung 1 umfasst des Weiteren eine Treibereinrichtung 20, eine bistabiles Relais 30, einen Energiespeicher 40 und eine Testeinrichtung 50. Das bistabile Relais 30 besitzt einen ersten und einen zweiten Spulenanschluss 31 und 32 sowie ein erstes Kontaktpaar 33 und 34 einer Öffnerkontakteinrichtung und ein zweites Kontaktpaar 35 und 36 eines Schließerkontakteinrichtung, die in Abhängigkeit des Schaltzustands des Relais geöffnet bzw. geschlossen sind.

Bei einer positiven Potentialdifferenz zwischen dem ersten 31 und dem zweiten Spulenanschluss 32 fließt ein entsprechender Strom vom ersten Spulenanschluss 31 über die Spulenwicklung zum zweiten Spulenanschluss 32, so dass das bistabile Relais 30 angezogen wird. Das Relais 30 wird gesetzt, so dass die Öffnerkontakteinrichtung geöffnet und die Schließerkontakteinrichtung entsprechend geschlossen wird. Mit einer umgekehrten Polarität der Spannung zwischen den beiden Spulenanschlüssen 31 und 32 fließt demnach ein entgegengesetzter Strom durch die Spule, so dass das Relais zurückgesetzt wird. Der zurückgesetzte Zustand des Relais 30 definiert in dem vorliegenden Beispiel den sicheren Zustand der Schaltvorrichtung 1.

Aus Gründen der Kompatibilität zu den üblichen unipolaren Sicherheitsrelais soll das bistabile Relais 30 beim Anlegen eines Eingangsignals an den Eingangssignalanschluss UA den gesetzten Zustand einnehmen. Liegt kein Signal an dem Signaleingangskreis der Schaltvorrichtung 1 an, so soll sich das Relais 30 im zurückgesetzten Zustand befinden bzw. in diesen geschaltet werden. D.h. bei einer steigenden Flanke des Eingangsignals wird das bistabile Relais 30 gesetzt, bei einer fallenden Flanke des Eingangsignals wird das Relais 30 zurückgesetzt.

Die Energie bzw. der Strom, der zum Schalten des bistabilen Relais 30 benötigt wird, wird vorzugsweise aus dem Signaleingangskreis gewonnen und somit von einem digitalen Ausgang einer SPS bereitgestellt. Alternativ kann an der Schaltvorrichtung 1 ein separater Hilfsenergieanschluss UB vorgesehen sein, an dem zum Beispiel eine externe Versorgungseinrichtung angeschlossen werden kann.

Die Steuerungseinrichtung 10 wertet den Zustand des an dem Eingangssignalanschluss UA anliegenden Eingangsignals aus und steuert zum Beispiel in Folge eines Pegelwechsels des Eingangssignalzustands das bistabile Relais 30 über die Treibereinrichtung 20 an. Die Treibereinrichtung 20 besitzt zum Beispiel zwei von der Steuerungseinrichtung 10 ansteuerbare Halbleiterschalter, die in der Figur 1 nicht dargestellt sind. Die beiden Halbleiterschalter können am ersten Spulenanschluss 31 jeweils ein definiertes Spannungspotential zum Auslösen eines Umschaltvorgangs im bistabilen Relais 30 bereitstellen. Mit einem ersten Halbleiterschalter kann der erste Spulenanschluss 31 mit dem Potential des Eingangssignalanschlusses UE oder alternativ mit dem Potential des Hilfsenergieanschlusses UB verbunden werden. Ein Spannungspotential am zweiten Spulenanschluss 32 kann durch den Energiespeicher 40 oder bedarfsweise auch über die Testeinrichtung 50 bereitgestellt werden.

Zum Setzen des bistabilen Relais 30, in Folge eines an der Eingangssignalanschluss UE anliegenden Eingangssignals, wird der erste Halbleiterschalter durchgeschaltet, so dass an dem ersten Spulenanschluss 31 eine positive Spannung anliegt, die aus dem Signaleingangskreis gewonnen oder von der externen Versorgungseinrichtung bereitgestellt wird. Der zweite Spulenanschluss 32 ist über den Energiespeicher 40 (z.B. ein Kondensator 41) mit dem Bezugspotential der Masseanschluss GND verbunden. Durch die Spannungsdifferenz zwischen dem ersten Spulenanschluss 31 und dem Masseanschluss GND fließt ein Strom durch die Spule des bistabilen Relais 30 in den Energiespeicher 40. Das bistabile Relais 30 wird somit in den gesetzten Zustand überführt. Gleichzeitig wird der im Einschaltzeitpunkt noch nicht geladene Energiespeicher 40 durch den, durch das bistabile Relais 30 fließenden Strom aufgeladen. Nach dem Aufladen des Energiespeichers 40 kann der erste Spulenanschluss 31 durch die Treibereinrichtung 20 von der Spannung des Eingangssignals bzw. von der dem Hilfsenergieanschluss UB getrennt werden, wobei das Relais 30 im gesetzten Zustand stabil verbleibt.

Zum Zurücksetzen des bistabilen Relais, beispielsweise in Folge einer fallenden Signalflanke an dem Eingangssignalanschluss UE, wird der erste Spulenanschluss 31 über die von der Steuerungseinrichtung 10 angesteuerte Treibereinrichtung 20 mit dem Bezugspotential der Schaltvorrichtung 1 verbunden. Der geladene Energiespeicher 40 stellt an dem zweiten Spulenanschluss 32 eine positive Spannung bereit. Durch die Potentialdifferenz zwischen den beiden Spulenanschlüssen fließt ein Strom von dem zweiten Spulenanschluss 32 über die Spule zu dem ersten Spulenanschluss 31, so dass bei dem bistabilen Relais 30 ein Wechsel in den zurückgesetzten Zustand erfolgt.

Je nach der schaltungstechnischen Ausgestaltung der Treibereinrichtung 20 kann gegebenenfalls ein vollständiges Entladen des Energiespeichers 40 notwendig sein, um ein erneutes Setzen des bistabilen Relais 30 zu ermöglichen.

Sofern eine externe Versorgungseinrichtung an der Schaltvorrichtung 1 angeschlossen ist, könnte die Spannung zum Zurücksetzen des bistabilen Relais 30 am zweiten Spulenanschluss 32 auch über den Hilfsenergieanschluss UB bereitgestellt werden. Entsprechende Verschaltungswege zum Beispiel über die Messeinrichtung 50 sind in den Figuren nicht dargestellt.

Der Energiespeicher 40 stellt jedenfalls eine von einer externen Energiequellen unabhängige Energieversorgung zum Zurücksetzen des bistabilen Relais 30 bereitstellt, wobei der zurückgesetzte Zustand den sicheren Schaltzustand des bistabilen Relais 30 definiert.

Um die SIL-Anforderungen zum Beispiel in Bezug auf das Ausfallverhalten eines bistabilen Sicherheitsrelais mit einer dargestellten Schaltvorrichtung 1 zu erfüllen, ist es erforderlich, eine für wenigstens einen Zustandswechsel, d.h. einen Wechsel in den als sicheren Zustand definierten Schaltzustand des Relais 30, ausreichend vorhandene Energie stets zu gewährleisten. Um diese Sicherheitsanforderung zu erfüllen, besitzt die dargestellte Schaltvorrichtung 1 die Testeinrichtung 50, die zum Energiespeicher 40 parallel in dem Ansteuerstrompfad des Relais 30 geschaltet ist und zum zyklischen Testen des Energiespeicher 40 ausgebildet ist. Die Testeinrichtung 50 steht über fünf Signalleitungen 60 mit der Steuereinrichtung 10 in Verbindung.

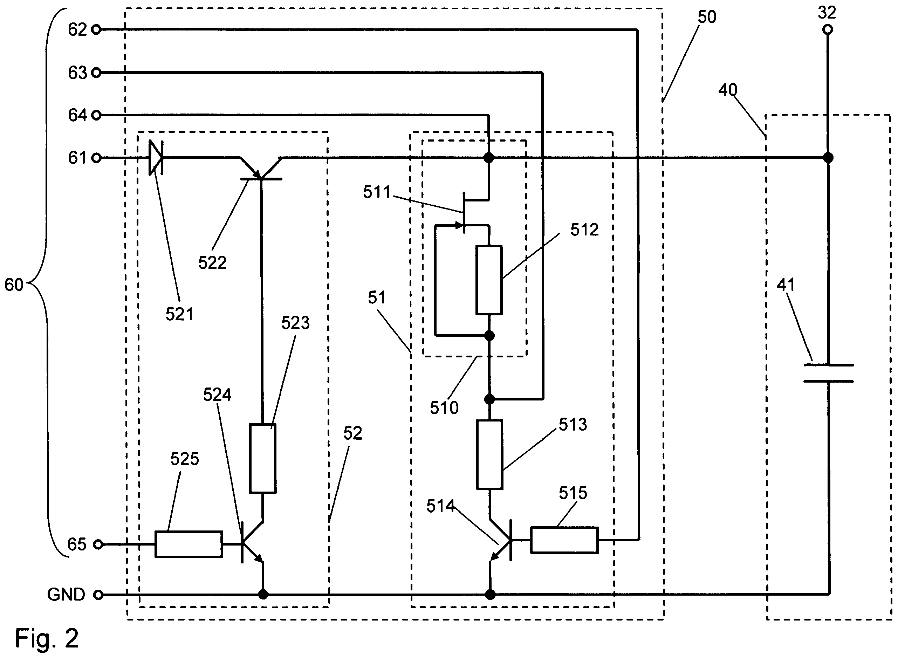

In der Figur 2 ist ein möglicher Aufbau der Testeinrichtung 50 an einem Schaltungsbeispiel verdeutlicht. Analog zu der Darstellung in der Figur 1 ist die Testeinrichtung 50 zum Einen mit dem Spulenanschluss 32 und zum Anderen mit dem Bezugspotential der Schaltvorrichtung verbunden. Der Energiespeicher 40 umfasst einen Kondensator 41, der zwischen dem zweiten Spulenanschluss 32 und dem Bezugspotential und somit zur Testeinrichtung 50 parallel geschaltet ist.

Die in der Figur 2 dargestellte Testschaltung 50 beinhaltet einen Messstrompfad 51, der einen Konstantstromregler 510 und einen Messwiderstand 513 umfasst. Der Messstrompfad 51 ist zum dem Kondensator 41 des Energiespeichers 40 parallel geschaltet angeordnet und kann über ein Schaltelement, das als npn-Bipolartransistor 514 dargestellt ist, aktiviert werden. Die Testschaltung 50 besitzt des Weiteren eine Ladeeinrichtung 52, die zum Nachladen des Energiespeichers dient und auch das bistabile Relais zurücksetzen kann.

Die Testeinrichtung 50 wird von der Steuerungseinrichtung 10 angesteuert. Mit Hilfe der Testeinrichtung 50 werden die Messwerte von der Steuerungseinrichtung 10 erfasst und entsprechend ausgewertet. Die Ansteuerung und Auswertung erfolgt über die fünf Signalleitungen 60, die gemäß der Figur 1 eine bidirektionale Verbindung zwischen der Testeinrichtung 50 und der Steuerungseinrichtung 10 bilden. Die fünf Signalleitungen 60 umfassen einen Ladespannungseingang 61, einen Testsignalanschluss 62, einen ersten und einen zweiten Messsignalanschluss 63 und 64 sowie einen Ladesignalanschluss 65.

Der Konstantstromregler 510 der Figur 2 umfasst beispielhaft einen Sperrschicht-Feldeffekttransistor (JFET) 511 mit einem auf das Gate rückgekoppelten Source-Widerstand 512. Alternativ könnte zum Beispiel auch eine Stromreglerdiode als Konstantstromregler anstelle der dargestellten Schaltung 511 und 521 verwendet werden. Wird der Messstrompfad 51 mit dem von der Steuerungseinrichtung 10 über den Testsignalanschluss 62 ansteuerbaren Bipolartransistor 514 aktiviert, so kann der Energiespeicher 40 mit einem konstanten Strom gezielt entladen werden. Der über den Messstrompfad 51 fließende Entladestrom kann über den korrelierenden Spannungsabfall an dem Messwiderstand 513 erfasst und somit von der Steuerungseinrichtung 10 auf Plausibilität geprüft werden.

An dem Ladespannungseingang 61 wird eine Spannung zum Nachladen des Kondensators 41 bereitgestellt, die innerhalb der Steuerungseinrichtung 10 aus dem Eingangssignal an dem Eingangssignalanschluss UE oder aus einer Spannung an dem Hilfsenergieanschluss UB gewonnen wird. Wird ein Signal an den Ladesignalanschluss 65 ausgegeben, so schaltet die Transistorstufe aus den beiden Bipolartransistoren 522 und 524 durch, so dass ein Ladestrom über die Entkopplungsdiode 521 in den Energiespeicher 40 fließt. Im Bedarfsfall, zum Beispiel bei einem erkannten Fehler im Energiespeicher 40, kann über die Ladespannungseingang 61 die elektrische Energie zum Zurücksetzen des bistabilen Relais 30 bereitgestellt werden, sofern eine ausreichende Spannung am Ladesignalanschluss 61 bereitsteht.

Die Steuerungseinrichtung 10 und die Testeinrichtung 50 können gemeinsam den Energiespeicher 40 zyklisch in einem Testverfahren testen und feststellen, ob der gespeicherte Energieinhalt zum sicheren Zurücksetzen des bistabilen Relais 30 ausreichend ist.

Das zyklische Testverfahren beginnt, nachdem die positive Spannung an dem ersten Spulenanschluss 31 nach Setzen des bistabilen Relais 30 und nach Aufladen des Energiespeichers 40 von der Treibereinrichtung 20 zurückgenommen worden ist.

Sofern die Energieversorgung der Schaltvorrichtung 1 über den separater Hilfsenergieanschluss UB bereitgestellt wird, so kann das zyklische Testverfahren unabhängig vom Zustand des bistabilen Relais, d.h. auch sofort mit dem Bereitstellen der Versorgungsspannung, kontinuierlich durchgeführt werden.

Zum Testen des Kondensators 41 wird ein positiver Spannungspegel von der Steuereinrichtung 10 an dem Testsignalanschluss 62 der Testeinrichtung 50 angelegt, so dass der Bipolartransistor 514 durchschaltet. Der zu dem Kondensator 41 parallel geschaltete Messstrompfad 51 wird somit aktiviert, so dass ein konstanter Entladestrom fließt. Über dem Messwiderstand 513 und dem Bipolartransistor 514 fällt eine dem fließenden Entladestrom proportionale Spannung ab, die über den ersten Messsignalanschluss 63 an die Steuerungseinrichtung 10 übertragen wird.

Die Steuereinrichtung 10, die beispielsweise einen Mikrokontroller umfassen kann, liest zum Beispiel über einen D/A-Wandler die über den ersten Messsignalanschluss 63 bereitgestellte Spannung ein und prüft diese auf Plausibilität, wobei der durch den Konstantstromregler 510 vorgesehene Entladestrom als Referenzwert in der Steuerungseinrichtung 10 abgelegt ist.

Während des Entladungsvorgangs wird die an dem Kondensator 41 anliegende Spannung über den zweiten Messsignalanschluss 64 von der Steuerungseinrichtung 10 fortlaufend erfasst. Die Entladungsdauer des Kondensators 41 während eines jeden Testzyklus entspricht entweder einem definierten Zeitraum oder wird durch das Erreichen einer minimalen Spannung am Kondensator 41 begrenzt.

Durch die zeitliche Messung der an dem Kondensator 41 anliegenden Spannung während der gesamten Entladungszeit ist der Steuerungseinrichtung 10 die am Kondensator 41 anliegende Spannung zu Beginn und zum Ende der Entladung bekannt. Dadurch, dass der Kondensator 41 mit einem konstanten Strom entladen wird, fällt die am Kondensator 41 anliegende Spannung linear mit der Entladungszeit ab. Dieser lineare Zusammenhang ermöglicht eine Berechnung eines Werts für die Kapazität des Kondensators 41.

Nachdem die Messwerte von der Steuerungseinrichtung 10 erfasst wurden, wird der Messstrompfad 51 deaktiviert und die Ladeeinrichtung 52 über ein positives Spannungssignal am Ladesignalanschluss 65 aktiviert. Der Kondensator wird somit nachgeladen.

Die Zeitdauer Δt und die Spannungsdifferenz ΔU der während des Entladens an dem Kondensator anliegenden und abnehmenden Spannung sind die relevanten Größen zur Berechnung der Kapazität, die messtechnisch durch einen Mikrokontroller der Steuerungseinrichtung 10 einfach erfasst werden können. Eine der beiden Messgrößen Δt oder ΔU wird für eine Messung festgesetzt. Der Entladestrom I ist, durch den Konstantstromregler 510 in dem Messstrompfad 51 vorgegeben. Gemäß den Gleichungen

$$\Delta W \; = \; \tfrac{1}{2} \; \cdot \; \Delta U \; \cdot \; I \; \cdot \; \Delta t$$

und

$$\Delta W \; = \; \tfrac{1}{2} \; \cdot \; \Delta U^2 \; \cdot \; C$$

berechnet sich die die Kapazität C des Kondensators 41 folgendermaßen:

$$C \; = \; (I \; \cdot \; \Delta t) \; / \; \Delta U \; .$$

Nach der Kapazitätsermittlung des Kondensators 41 kann zum Beispiel der ermittelte Wert mit einem Sollwert für die Kapazität C verglichen werden. Wird ein geforderter Kapazitätswert bei der Messung nicht erreicht, so kann auf einen Fehler in dem Kondensator 41 geschlossen werden.

Durch einen zyklisch schnellen Wechsel zwischen Messvorgang und Nachladen, der z.B. mit einer Periodendauer im Bereich von 20 ms bis 100 ms erfolgen kann, kann die zuvor beschriebene statische Messung in ein dynamisches Testverfahren überführt werden.

Ein Signal, das von der Steuerungseinrichtung 10 und der Testeinrichtung 50 generiert worden ist, würde bei einem Abweichen der Kapazität C des Kondensators 41 entsprechend verstimmt werden. Ein mit der dynamisch betriebenen Testeinrichtung 50 erfasste Signalform muss einem in der Steuerungseinrichtung 10 definierten Signal innerhalb eines vorbestimmten Toleranzbereichs übereinstimmen, andernfalls wird ein Fehler bzw. eine fehlerhafte Kapazität in dem Kondensator 41 erkannt.

Mit einer solchen dynamischen Testeinrichtung lässt sich ein hoher Diagnosedeckungsgrad von 99 % erreicht. So können zum Beispiel auch die in der europäischen Norm EN 61508-2, Teil 2, Tabelle A3 "Hardware mit automatischen Tests" oder Tabelle A3 "Inspektion durch Verwendung von Testmuster" definierten Anforderungen erfüllt werden.

Erkennt die Steuerungseinrichtung 10 einen Fehler in dem Energiespeicher, so wird das bistabile Relais 30 mittels der Treibereinrichtung 20, welche durch eine am Ladespannungseingang 61 anliegende Spannung gespeist wird, in den sichern Zustand zurückgesetzt.

Ein von der Steuerungseinrichtung 10 erkannter Fehler kann zusätzlich über den Ausgangssignalanschluss UA zum Beispiel an eine übergeordnete Steuerungseinrichtung signalisiert werden. Insbesondere dann, wenn aufgrund einer Störung ein Zurücksetzen des bistabilen Relais nicht mehr möglich ist, kann über den signalisierten Fehler ein weiterer, d.h. redundanter Abschaltweg initiiert werden.

**Bezugszeichenliste**

| | |
|---|---|
| 1 | Schaltvorrichtung |
| 10 | Steuerungseinrichtung |
| 20 | Treibereinrichtung |
| 30 | bistabiles Relais |
| 31 | erster Spulenanschluss |
| 32 | zweiter Spulenanschluss |
| 33 | erste Öffneranschlussklemme |
| 34 | zweite Öffneranschlussklemme |
| 35 | erste Schließeranschlussklemme |
| 36 | zweite Schließeranschlussklemme |
| 40 | Energiespeicher |
| 41 | Kondensator |
| 50 | Testeinrichtung |
| 51 | Messstrompfad |
| 510 | Konstantstromregler |
| 511 | Sperrschicht-Feldeffekttransistor (JFET) |
| 512 | Widerstand |
| 513 | Messwiderstand |
| 514 | Schaltelement / npn-Bipolartransistor |
| 515 | Widerstand |
| 52 | Ladeeinrichtung |
| 521 | Entkopplungsdiode |
| 522 | pnp-Bipolartransistor |
| 523 | Widerstand |
| 524 | npn-Bipolartransistor |
| 525 | Basiswiderstand |
| 60 | fünf Signalleitungen |
| 61 | Ladespannungseingang |
| 62 | Testsignalanschluss |
| 63 | erster Messsignalanschluss |
| 64 | zweiter Messsignalanschluss |
| 65 | Ladesignalanschluss |
| GND | Masseanschluss |
| UE | Eingangssignalanschluss |
| UB | Hilfsenergieanschluss |
| UA | Ausgangssignalanschluss |

**Patentansprüche**

1. Schaltvorrichtung (1) umfassend

   - ein bistabiles Relais (30), das zwischen einem gesetzten und einem zurückgesetzten Zustand in Abhängigkeit von je einem zugeordneten Steuerstrom umschaltbar ist; um wenigstens einen Ausgangsstromkreis (35, 36) zu schalten,
   - einen Energiespeicher (40) zum Bereitstellen der Energie für wenigstens einen Zustandswechsel des bistabilen Relais (30),
   - eine Testeinrichtung (50) zum Testen der Funktionsfähigkeit des Energiespeichers (40) und
   - eine Steuereinrichtung (10), die zum Ansteuern des Relais (30) ausgebildet ist, **dadurch gekennzeichnet,**

   **dass** die Steuereinrichtung (10) einen Eingangssignalanschluss (UE) für ein Eingangsspannungssignal und einen Masseanschluss (GND) mit einem Bezugspotential aufweist, die den Signaleingangskreis der Schalteinrichtung (1) bilden und mit einer speicherprogrammierbaren Steuerung verbunden sind, die sicherheitsgerichtete Funktionen eines Automatisierungssystems bereitstellt, wobei beim Anlegen eines Eingangssignals an den Eingangssignalanschluss (UE) das bistabile Relais (30) den gesetzten Zustand einnimmt und bei Fehlen des Signals der zurückgesetzte Zustand des Relais (30), der den sicheren Zustand der Schaltvorrichtung (1) definiert, eingenommen wird.

2. Schaltvorrichtung (1) nach Anspruch 1, wobei die Steuerungseinrichtung (10) und die Testeinrichtung (50) über Signalleitungen (60) miteinander in bidirektionaler Verbindung stehen und hierzu einen Ladespannungseingang (61), einen Testsignalanschluss (62), einen ersten und zweiten Messsignalanschluss (63, 64) sowie einen Ladesignalanschluss (65) aufweisen und dazu ausgebildet sind, beim Erkennen eines Fehlers des Energiespeichers (30) das bistabile Relais (10) in den zurückgesetzten Zustand zu setzen.

3. Schaltvorrichtung (1) gemäß einem der vorstehenden Ansprüche, wobei die Testeinrichtung (50) einen Messstrompfad (51) besitzt, der zum Energiespeicher (40) parallel geschaltet ist.

4. Schaltvorrichtung (1) nach Anspruch 3, wobei der Messstrompfad (51) einen Konstantstromregler (510), einen Messwiderstand (513) und ein Schaltelement (514) umfasst.

5. Schaltvorrichtung (1) nach Ansprüchen 2 bis 4, wobei der Messstrompfad (51) der Testeinrichtung (50) über den Testsignalanschluss (62) von der Steuerungseinrichtung (10) schaltbar ist, und wobei ein durch den Messstrompfad (51) fließender Strom über den ersten Messsignalanschluss (63) von der Steuerungseinrichtung (10) detektierbar ist.

6. Schaltvorrichtung (1) gemäß einem der vorstehenden Ansprüche 2 bis 5, wobei eine an dem Energiespeicher (40) anliegende Spannung über den zweiten Messsignalanschluss (64) von der Steuerungseinrichtung (10) detektierbar ist.

7. Schaltvorrichtung (1) gemäß einem der vorstehenden Ansprüche 1 bis 6, wobei die Testeinrichtung (50) eine Ladeeinrichtung (52) zum Aufladen des Energiespeichers (40) aufweist.

8. Schaltvorrichtung (1) nach Anspruch 7, wobei die Testeinrichtung (50) zum zyklischen Testen und die Ladeeinrichtung (52) zum zyklischen Aufladen des Energiespeichers (40) ausgebildet sind.

9. Schaltvorrichtung (1) gemäß einem der vorstehenden Ansprüche 1 bis 8, wobei der Energiespeicher (40) wenigstens einen Kondensator (41) aufweist.

10. Testverfahren zum Testen der Funktionsfähigkeit des Energiespeichers (40) der Schaltvorrichtung (1) nach einem der vorstehenden Ansprüche 2 bis 9, umfassend folgende Schritte:

    a) Aufladen des Energiespeichers (40) während eines anliegenden Eingangsspannungssignals (UE) oder über einen separaten Hilfsenergieanschluss (UB) beziehungsweise Nachladen des Energiespeichers (40), gesteuert über den Ladesignalanschluss (65);

    b) Aktivieren des Testsignalanschlusses (62) und Entladen des Energiespeichers (40) über einen Messwiderstand (513) mit einem definierten konstanten Strom während einer vorbestimmten Testzeit;

    c) über den ersten Messsignalanschluss (63) Abgreifen der am Messwiderstand (513) abfallenden Spannung und dadurch Messen der am Energiespeicher (40) während der Testzeit anliegenden Spannung;

    d) Ermitteln der Kapazität des Energiespeichers (40) in Abhängigkeit der in Schritt c) gemessenen Spannung und

    e) Prüfen, ob die Kapazität innerhalb eines definierten Wertebereichs liegt.

11. Testverfahren gemäß vorstehendem Anspruch 10, wobei die Schritte a) bis e) zyklisch wiederholt werden.

12. Testverfahren gemäß einem der beiden vorstehenden Ansprüche 10 oder 11, wobei in Abhängigkeit eines Abweichens der ermittelten Kapazität von dem definierten Wertbereich ein Fehler im Energiespeicher (40) erkannt wird.

13. Testverfahren nach Anspruch 11 oder 12, wobei durch einen zyklisch schnellen Wechsel zwischen Messvorgang und Nachladen, ausgeführt durch zyklisches Wiederholen der Schritte a) bis e), ein periodisches Testsignal erzeugt wird, das bei Abweichen der Kapazität von dem definierten Wertbereich verstimmt wird.

14. Testverfahren gemäß einem der Ansprüche 10 bis 14, wobei der Strom während des Entladens des Energiespeichers (40) ermittelt wird und wenn der ermittelte Strom vom Wert des definierten konstanten Strom abweicht, ein Fehler im Energiespeicher (40) erkannt wird.

15. Testverfahren gemäß vorstehendem Anspruch 14, wobei beim Erkennen eines Fehlers das bistabile Relais (30) in den zurückgesetzten Zustand gesetzt wird.

**Claims**

1. A switching device (1), comprising:

    - a bistable relay (30) which is switchable between a set state and a reset state as a function of a respective associated control current, in order to switch at least one output circuit (35, 36);
- an energy storage (40) for providing the energy for at least one state change of the bistable relay (30);
- a test device (50) for testing the operability of the energy storage (40); and
- a control device (10) adapted for driving said relay (30); **characterized in that**

the control device (10) has an input signal terminal (UE) for a voltage input signal and a ground terminal (GND) at a reference potential, which form the signal input circuit of the switching device (1) and which are coupled with a programmable logic controller which provides safety-related functionality of an automation system, wherein, when an input signal is applied to the input signal terminal (UE), the bistable relay (30) assumes the set state, and wherein in the absence of the signal, the reset state of the relay (30) is assumed, which defines the safe state of the switching device (1) .

2. The switching device (1) according to claim 1, wherein the control device (10) and the test device (50) are interconnected bidirectionally via signal lines (60) and for this purpose have a charging voltage input (61), a test signal terminal (62), a first and a second measurement signal terminal (63, 64), and a charging signal terminal (65) and are adapted to set the bistable relay (10) into the reset state when a fault of the energy storage (40) is detected.

3. The switching device (1) according to any one of the preceding claims, wherein the test device (50) has a measuring current path (51) which is connected in parallel with the energy storage (40).

4. The switching device (1) according to claim 3, wherein the measuring current path (51) comprises a constant current controller (510), a measuring resistor (513), and a switching element (514).

5. The switching device (1) according to claims 2 to 4, wherein the measuring current path (51) of the test device (50) is switchable by the control device (10) via the test signal terminal (62), and wherein a current flowing through the measuring current path (51) is detectable by the control device (10) via the first measurement signal terminal (63).

6. The switching device (1) according to any one of the preceding claims 2 to 5, wherein a voltage applied to the energy storage (40) is detectable by the control device (10) via the second measurement signal connection (64).

7. The switching device (1) according to any one of the preceding claims 1 to 6,

wherein the test device (50) comprises a charging device (52) for charging the energy storage (40).

8. The switching device (1) according to claim 7, wherein the test device (50) is adapted for cyclic testing, and wherein the charging device (52) is adapted for cyclic charging of the energy storage (40).

9. The switching device (1) according to any one of the preceding claims 1 to 8, wherein the energy storage (40) includes at least one capacitor (41).

10. A testing method for testing the operability of the energy storage (40) of the switching device (1) according to any one of the preceding claims 2 to 9, comprising the steps of:

a) charging the energy storage (40) while an input voltage signal (UE) is applied or via a separate auxiliary energy terminal (UB), or recharging the energy storage (40), controlled via the charging signal terminal (65);
b) enabling the test signal terminal (62) and discharging the energy storage (40) via a measuring resistor (513) with a defined constant current during a predetermined test period;
c) tapping the voltage drop across the measuring resistor (513) via the first measurement signal terminal (63) and thereby measuring the voltage applied to the energy storage (40) during the test period;
d) determining the capacitance of the energy storage (40) on the basis of the voltage measured in step c); and
e) checking whether the capacitance is within a predefined value range.

11. The testing method according to the preceding claim 10, wherein steps a) to e) are repeated cyclically.

12. The testing method according to any one of the two preceding claims 10 or 11, wherein a fault in the energy storage (40) is detected from a deviation of the determined capacitance from the predefined value range.

13. The testing method according to claim 11 or 12, wherein, by a fast cyclic change between measurement operation and recharging effected by cyclically repeating steps a) to e), a periodic test signal is generated which is detuned when the capacitance deviates from the predefined value range.

14. The testing method according to any one of claims 10 to 14, wherein the current is determined during the discharging of the energy storage (40), and if the determined current deviates from the value of the predefined constant current, a fault is detected in the energy storage (40).

15. The testing method according to the preceding claim 14,
wherein upon detection of a fault, the bistable relay (30) is set into the reset state.


**Revendications**

1. Dispositif de commutation (1) comprenant :

   - un relais bistable (30), qui peut basculer entre un état activé et un état remis à zéro en fonction d'un courant de commande respectif associé, afin de commuter au moins un circuit de courant de sortie (35, 36),
   - un accumulateur d'énergie (40) servant à fournir l'énergie pour au moins un changement d'état du relais bistable (30),
   - un dispositif d'essai (50) servant à tester le bon fonctionnement de l'accumulateur d'énergie (40) et
   - un dispositif de commande (10), qui est conçu pour commander le relais (30), **caractérisé**

   **en ce que** le dispositif de commande (10) comprend un raccord de signal d'entrée (UE) pour un signal de tension d'entrée et un raccord de masse (GND) pourvu d'un potentiel de référence, qui forment le circuit d'entrée de signal du dispositif de commutation (1) et qui sont reliés à une commande par programme enregistré, qui fournit les fonctions de sécurité d'un système d'automatisation, dans lequel le relais bistable (30), lorsqu'un signal d'entrée est appliqué sur le raccord de signal d'entrée (UE), occupe l'état activé et, en l'absence du signal, l'état remis à zéro du relais (30), qui définit l'état sécurisé du dispositif de commutation, est occupé.

2. Dispositif de commutation (1) selon la revendication 1, dans lequel le dispositif de commande (10) et le dispositif d'essai (50) sont en liaison bidirectionnelle l'un avec l'autre par l'intermédiaire de lignes de signaux (60) et comprennent à cet effet une entrée de tension de charge (61), un raccord de signal d'essai (62), un premier et un deuxième raccord de signal de mesure (63, 64) ainsi qu'un raccord de signal de charge (65) et sont conçus pour placer le relais bistable (10) dans l'état remis à zéro en cas de détection d'une erreur de l'accumulateur d'énergie (30).

3. Dispositif de commutation (1) selon l'une quelconque des revendications précédentes, dans lequel le dispositif d'essai (50) possède un chemin de courant de mesure (51) qui est monté en parallèle de l'accumulateur d'énergie (40).

4. Dispositif de commutation (1) selon la revendication 3, dans lequel le chemin de courant de mesure (51) comprend un régulateur de courant constant (510), une résistance de mesure (513) et un élément de commutation (514).

5. Dispositif de commutation (1) selon les revendications 2 à 4, dans lequel le chemin de courant de mesure (51) du dispositif d'essai (50) peut être commuté par le dispositif de commande (10) par l'intermédiaire du raccord de signal d'essai (62), et dans lequel un courant circulant à travers le chemin de courant de mesure (51) peut être détecté par le dispositif de commande (10) par l'intermédiaire du premier raccord de signal de mesure (63).

6. Dispositif de commutation (1) selon l'une quelconque des revendications 2 à 5 précédentes, dans lequel une tension appliquée sur l'accumulateur d'énergie (40) peut être détectée par le dispositif de commande (10) par l'intermédiaire du deuxième raccord de signal de mesure (64).

7. Dispositif de commutation (1) selon l'une quelconque des revendications 1 à 6 précédentes, dans lequel le dispositif d'essai (50) comprend un dispositif de charge (52) servant à charger l'accumulateur d'énergie (40).

8. Dispositif de commutation (1) selon la revendication 7, dans lequel le dispositif d'essai (50) est conçu pour l'essai cyclique et le dispositif de charge (52) pour la charge cyclique de l'accumulateur d'énergie (40).

9. Dispositif de commutation (1) selon l'une quelconque des revendications 1 à 8 précédentes, dans lequel l'accumulateur d'énergie (40) comprend au moins un condensateur (41).

10. Procédé d'essai permettant de tester le bon fonctionnement de l'accumulateur d'énergie (40) du dispositif de commutation (1) selon l'une quelconque des revendications 2 à 9 précédentes, comprenant les étapes suivantes :

    a) charger l'accumulateur d'énergie (40) pendant un signal de tension d'entrée (UE) appliqué ou, par l'intermédiaire d'un raccord d'énergie auxiliaire (UB) séparé, recharger l'accumulateur d'énergie (40), de façon commandée par le raccord de signal de charge (65) ;
    b) activer le raccord de signal d'essai (62) et la décharge de l'accumulateur d'énergie (40) par l'intermédiaire d'une résistance de mesure (513) au moyen d'un courant constant défini pendant une période d'essai prédéfinie ;

c) par l'intermédiaire du premier raccord de signal de mesure (63), prélever la tension en chute sur la résistance de mesure (513) et mesurer ainsi la tension appliquée sur l'accumulateur d'énergie (40) pendant la période d'essai ;

d) déterminer la capacité de l'accumulateur d'énergie (40) en fonction de la tension mesurée à l'étape c) et

e) contrôler si la capacité se situe à l'intérieur d'une plage de valeurs définie.

11. Procédé d'essai selon la revendication 10 précédente, dans lequel les étapes a) à e) sont répétées de manière cyclique.

12. Procédé d'essai selon l'une des deux revendications précédentes 10 et 11, dans lequel une erreur dans l'accumulateur d'énergie (40) est détectée en fonction d'un écart entre la capacité déterminée et la plage de valeurs définie.

13. Procédé d'essai selon la revendication 11 ou 12, dans lequel un changement cycliquement rapide entre la procédure de mesure et la recharge, exécuté par répétition cyclique des étapes a) à e), permet de produire un signal d'essai périodique qui, en cas d'écart entre la capacité et la plage de valeurs définie, est désaccordé.

14. Procédé d'essai selon l'une quelconque des revendications 10 à 14, dans lequel le courant est déterminé pendant la décharge de l'accumulateur d'énergie (40) et, lorsque le courant déterminé s'écarte de la valeur du courant constant défini, une erreur dans l'accumulateur d'énergie (40) est détectée.

15. Procédé d'essai selon la revendication 14 précédente, dans lequel le relais bistable (30) est placé dans l'état remis à zéro en cas de détection d'erreur.

Fig. 1

EP 2 546 852 B1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10140559 A1
- EP 2383764 A1
- EP 2290383 A1